# EUROPEAN PATENT SPECIFICATION

(11) **EP 2 053 636 B1**
(45) Date of publication and mention of the grant of the patent: **17.12.2014**
(21) Application number: 08157629.0
(22) Date of filing: 05.06.2008
(51) Int. Cl.: H01L 21/18, H01L 29/24, H01L 29/51, H01L 29/78, H01L 21/336

(54) **Method of manufacturing a semiconductor device**
Verfahren zur Herstellung eines Halbleiterbauelements
Procédé de fabrication d'un dispositif semi-conducteur

(30) Priority: 08.06.2007 JP 2007153006; 26.12.2007 JP 2007333626
(43) Date of publication of application: 29.04.2009
(73) Proprietor: Nissan Motor Co., Ltd., Kanagawa 221-0023 (JP)
(72) Inventor: Yamagami, Shigeharu, Atsugi-shi Kanagawa 243-0123 (JP); Hoshi, Masakatsu, Atsugi-shi Kanagawa 243-0123 (JP); Hayashi, Tetsuya, Atsugi-shi Kanagawa 243-0123 (JP); Tanaka, Hidaki, Atsugi-shi Kanagawa 243-0123 (JP)
(74) Representative: Hager, Thomas Johannes

(56) References cited:
- JP-A- 2003 318 398
- JP-A- 2006 100 310
- US-A1- 2004 217 358
- S. BANERJEE ET AL: "Effect of processing conditions on inversion layer mobility and interface state density in 4H-SiC MOSFETs", JOURNAL OF ELECTRONIC MATERIALS, vol. 30, no. 3, 1 March 2001 (2001-03-01), pages 253-259, XP55021972, ISSN: 0361-5235, DOI: 10.1007/s11664-001-0025-z
- ECKHARD PIPPEL ET AL: "Interfaces between 4H-SiC and SiO[sub 2]: Microstructure, nanochemistry, and near-interface traps", JOURNAL OF APPLIED PHYSICS, vol. 97, no. 3, 30 December 2004 (2004-12-30), pages 034302-1-034302-8, XP55022076, ISSN: 0021-8979, DOI: 10.1063/1.1836004

## Description

The present invention relates to a method of manufacturing a semiconductor device.

Japanese Laid-Open Patent Publication No. 2003-318398 discloses a semiconductor device. In such a device, an N⁻-type polycrystal silicon region and an N⁺-type polycrystal silicon region are formed and adjoined to a main surface of a sem iconductor substrate, in which an N⁻-type silicon carbide epitaxial region is formed on an N⁺-type silicon carbide substrate. The N⁻-type silicon carbide epitaxial region, the N⁻-type polycrystal silicon region and the N⁺-type polycrystal silicon region form a heterojunction. Further, a gate electrode is formed adjacent to a junction portion of the N⁻-type silicon carbide epitaxial region and the N⁺-type polycrystal silicon region via a gate insulation film. The N⁻-type polycrystal silicon region is connected to a source electrode and a drain electrode is formed on another surface of the N⁺-type silicon carbide substrate.

The above-mentioned semiconductor device is manufactured by using the polycrystal silicon as a hetero semiconductor region and the gate insulating film is formed by depositing a chemical vapor deposition (CVD) oxide film on a polycrystal silicon layer. Further, the polycrystal silicon layer is deposited on the gate insulating film once again. Nonetheless, the interface characteristic is deteriorated since there are a plenty of defective crystals in a grain boundary between crystal grains in a junction interface of the gate insulating film formed by a deposition method and the silicon carbide epitaxial layer (i.e., the interface state density is increased).

Document US 2004/217358 discloses a method of manufacturing a SiC semiconductor device.

It is an aim of the present invention to address this issue. Other aims and advantages of the invention will become apparent from the following description, claims and drawings.

Aspects of the invention therefore provide a method as claimed in the appended claims.

In an embodiment, a thickness of the second insulating film between the exposed surfaces of the hetero semiconductor region and the first insulating film is no more than about two times a thickness of the second insulating film between the exposed portions of the first surface of the semiconductor substrate and the first insulating film.

The method may comprise depositing a gate electrode on an exposed surface of the first insulating film opposite the second insulating film, forming a source electrode in electrical contact with the hetero semiconductor region and forming a drain electrode in ohmic-connection with the semiconductor substrate on a second surface of the semiconductor substrate opposed to the first surface.

In an embodiment, forming the second insulating film includes performing at least one of a wet oxidization, a dry oxidization and a pyrogenic oxidization.

In an embodiment, the semiconductor material comprises at least one of silicon carbide, gallium nitride and diamond.

In an embodiment, the hetero semiconductor material is polycrystal silicon.

According to examples not forming part of the invention there is provided a semiconductor device made according to a method set out in any of the preceding paragraphs.

In an example, a thickness of the second insulating film between the exposed surfaces of the hetero semiconductor region and the first insulating film is no more than about two times a thickness of the second insulating film between the exposed portions of the first surface of the semiconductor substrate and the first insulating film.

The device may comprise a gate electrode on an exposed surface of the first insulating film opposite the second insulating film, a source electrode in electrical contact with the hetero semiconductor region and a drain electrode in ohmic-connection with the semiconductor substrate on a second surface of the semiconductor substrate opposed to the first surface.

In an example, the semiconductor material comprises at least one of silicon carbide, gallium nitride and diamond.

In an example, the hetero semiconductor material comprises at least one of monocrystal silicon, polycrystal silicon, amorphous silicon, germanium, silicon germanium and gallium arsenide.

For example, a semiconductor device may comprise a semiconductor substrate and a hetero semiconductor region including a semiconductor material having a band gap different from that of the semiconductor substrate and contacting a portion of a first surface of the semiconductor substrate. One method taught herein comprises depositing a first insulating film on exposed portions of the first surface of the semiconductor substrate and on exposed surfaces of the hetero sem iconductor material and forming a second insulating film between the first insulating film and facing surfaces of the semiconductor substrate and the hetero semiconductor region by performing a thermal treatment in an oxidizing atmosphere.

The present invention will now be described, by way of example only, with reference to the accompanying drawings, in which:
FIG. 1 is a cross-sectional view of a semiconductor device manufactured by a method according to embodiments of the invention;
FIGS. 2A to 2H are diagrams illustrating the method of manufacturing the semiconductor device in accordance with a first example;
FIG. 3 is a schematic view of oxidization rate changes of silicon; and
FIGS. 4A to 4G are diagrams illustrating a method of manufacturing a semiconductor device in accordance with an embodiment of the invention.

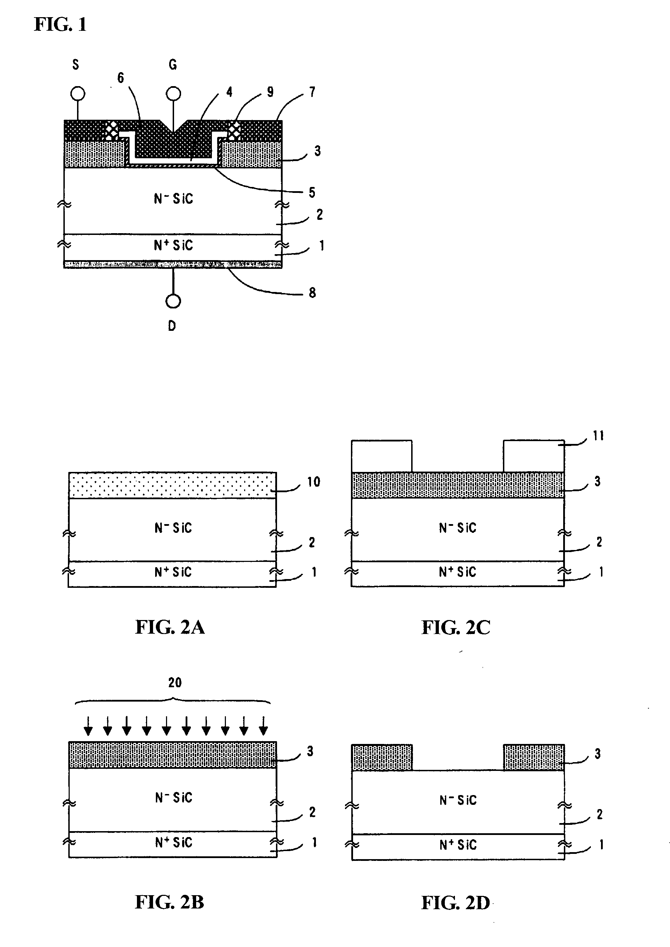

As shown in FIG.1, the semiconductor device manufactured by the method according to one embodiment is configured to arrange two unit cells of a field effect transistor so that they face each other. A single field effect transistor is formed by arranging and connecting a plurality of unit cells in parallel. As shown in FIG. 1, the semiconductor device comprises a silicon carbide substrate as a base material, wherein silicon carbide is a semiconductor material. The semiconductor substrate according to the present embodiment is formed from an N⁺-type silicon carbide substrate 1 in N-type high concentration (N⁺-type) and an N⁻-type silicon carbide epitaxial layer 2 in N-type low concentration (N⁻-type). The N⁻-type silicon carbide epitaxial layer 2 is formed on a main surface of the N⁺-type silicon carbide substrate 1. Although there are several polycrystal types of the silicon carbide, the silicon carbide having a representative 4H polycrystal type is used in this embodiment.

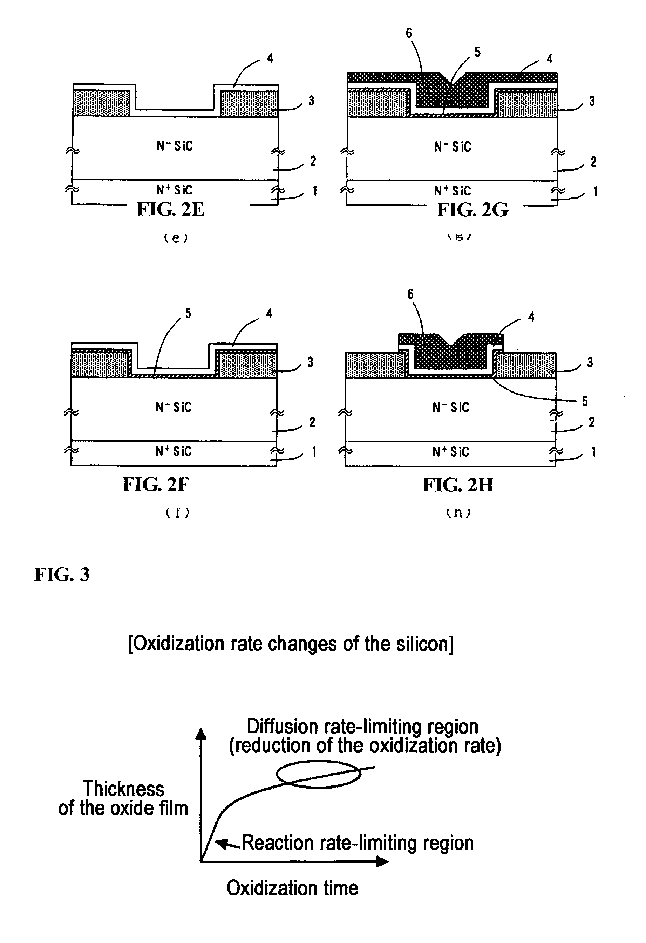

The N⁺-type silicon carbide substrate 1 has a thickness ranging from tens of µm to hundreds of µm. The N⁻-type silicon carbide epitaxial layer 2 has a thickness ranging from several µm to tens of µm. A semiconductor device of this embodiment also comprises an N⁺-type polycrystal silicon 3. The N⁺-type polycrystal silicon 3 is a semiconductor that contacts a surface of the N⁻-type silicon carbide epitaxial layer 2 opposite from the surface of the N⁻-type silicon carbide epitaxial layer 2 contacting the N⁺-type silicon carbide substrate 1. As explained below, the N⁺-type polycrystal silicon 3 is formed by adopting a polycrystal silicon 10 (see FIG. 2), which is a semiconductor having a band gap different from the silicon carbide, as a base material and introducing N-type impurities 20 (see FIG. 2) to thereby create a hetero semiconductor region. As a result, the N⁻-type silicon carbide epitaxial layer 2 and the N⁺-type polycrystal silicon 3 form a heterojunction. A groove extending to the N⁻-type silicon carbide epitaxial layer 2 is then formed in the N⁺-type polycrystal silicon 3.

The insulating film and the gate electrode 6 are formed in such a groove. The insulating film is formed of a gate insulating film (thermal oxide film) 5 and a gate insulating film (depositing film) 4. Specifically, the gate insulating film 5 contacts a surface of the N⁻-type silicon carbide epitaxial layer 2, a side surface of the N⁺-type polycrystal silicon 3 and a part of the heterojunction portion. Further, the gate insulating film 5 contacts a surface of the N⁺-type polycrystal silicon 3, i.e., a part of a surface facing the N⁻-type silicon carbide epitaxial layer 2. The depositing film 4 is formed on a surface of the thermal oxide film 5 that is opposite from the surface of the thermal oxide film 5 facing the N⁻-type silicon carbide epitaxial layer 2. The gate electrode 6 is form ed on a surface of the depositing film 4 that is opposite from the surface of the depositing film 4 facing the thermal oxide film 5. Thus, the gate electrode 6 contacts a part of the heterojunction portion via the depositing film 4 and the thermal oxide film 5.

A source electrode 7 is connected to a surface of the N⁺-type polycrystal silicon 3. To insulate the source electrode 7 and the gate electrode 6, an interlayer insulating film 9 is formed between the source electrode 7 and the gate electrode 6. A drain electrode 8 is then formed on the surface of the N⁺-type silicon carbide substrate 1 that is opposite from the surface of the N⁺-type silicon carbide substrate 1 facing the N⁻-type silicon carbide epitaxial layer 2. The drain electrode 8 is electrically ohmic-connected to the N⁺-type silicon carbide substrate 1 at a low resistance. In addition, a termination structure (not shown) such as a guard ring, etc., is adopted at an outermost peripheral portion of a chip of the field effect transistor, in which a plurality of the semiconductor devices made with a method taught herein is connected in parallel. Due to such a termination structure, when the field effect transistor is off, a field concentration therearound is alleviated, thereby accomplishing a high pressure resistance. Since such a field effect transistor may adopt a general termination structure used in a power device field, explanations of the termination structure are omitted herein.

The semiconductor device shown in FIG. 1 serves as a switch by controlling an electric potential of the gate electrode 6 when the source electrode 7 is grounded and a predetermined positive electrical potential is applied to the drain electrode 8. That is, when the gate electrode 6 is grounded, since a reverse bias is applied to a heterojunction portion of the N⁺-type polycrystal silicon 3 and the N⁻-type silicon carbide epitaxial layer 2, the current does not flow between the drain electrode 8 and the source electrode 7. However, when a predetermined positive voltage is applied to the gate electrode 6, a gate electrical field affects the heterojunction surface of the N⁺-type polycrystal silicon 3 and the N⁻-type silicon carbide epitaxial layer 2. Thus, since a thickness of an energy barrier formed by the heterojunction surface becomes thinner, the current flows between the drain electrode 8 and the source electrode 7. Since the heterojunction portion is used as a control channel for blocking and conducting the current, a length of the channel depends on a thickness of a hetero barrier. Consequently, a low resistance conduction characteristic is obtained.

FIGS. 2A to 2H show a method of manufacturing the semiconductor device according to the first example. First, as shown in FIG. 2A, the N⁻-type silicon carbide epitaxial layer 2 having an impurity concentration generally ranging from about 10¹⁴ to about 10¹⁸ cm⁻³ and a thickness ranging from several µm to tens of µm is formed on the surface of the N⁺-type silicon carbide substrate 1. Then, the polycrystal silicon 10 is deposited on the exposed surface of the N⁻-type silicon carbide epitaxial layer 2. The deposition method may include a low pressure CVD process. Next, as shown in FIG. 2B, the N⁺-type polycrystal silicon 3 is prepared by introducing the N-type impurities 20 into the polycrystal silicon 10. According to this example, the method of introducing the N-type impurities 20 may include a method of thermally diffusing the N-type impurities 20 after depositing the polycrystal silicon 10.

However, a method of introducing the N-type impurities 20 during the deposition of the polycrystal silicon 10 or ion-injecting the N-type impurities 20 after depositing the polycrystal silicon 10 may alternatively be used.

Next, as shown in FIG. 2C, a resist mask 11 is formed by applying a resist on the surface of the N⁺-type polycrystal silicon 3 and patterning by a photolithography. Then, as shown in FIG. 2D, the N⁺-type polycrystal silicon 3 is etched by adopting the resist mask 11 as a mask to expose a portion of the N⁻-type silicon carbide epitaxial layer 2.

Thereafter, the resist mask 11 is removed. The etching method may include dry etching. Then, in the process shown in FIG. 2E, the depositing film 4 is, for example, deposited for about 1000 Å (1Å = 0.1 nm) to thereby contact the N⁻-type silicon carbide epitaxial layer 2 and the N⁺-type polycrystal silicon 3 (polycrystal silicon 10). As for the depositing film 4, a silicon oxide film can be appropriately used. Further, the deposition method may include a thermal CVD method, a plasma CVD method or a sputter method.

In the process shown in FIG. 2F, after the depositing film 4 is deposited, a thermal treatment is performed in an oxidizing atmosphere. The oxidizing atmosphere may include atmospheres used in each of a wet oxidization, a dry oxidization and a pyrogenic oxidization, etc. The temperature of the thermal treatment may be, for example, about 1100°C. By the process shown in FIG. 2F, oxygen diffused in the previously deposited depositing film 4 arrives at the interface of the N⁻-type silicon carbide epitaxial layer 2 and the depositing film 4, thereby oxidizing the N⁻-type silicon carbide epitaxial layer 2 for several A to tens of A. Simultaneously, the surface and side surface of the N⁺-type polycrystal silicon 3 are oxidized. Thus, the thermal oxide film 5 is formed. Due to the thermal oxide film 5 formed in the above oxidization process, it is possible to reduce the interface state density.

If the depositing film 4 were deposited after the N⁻-type silicon carbide epitaxial layer 2 is oxidized for several Å to tens of Å (1Å = 0.1 nm), an exposed portion of the N⁻-type silicon carbide epitaxial layer 2 may be exposed to an outer space between an oxidization process and a deposition process. As a result, there is a concern that such an exposed portion may be contaminated by the impurities from the outer space. However, in the first embodiment, the interface of the N⁻-type silicon carbide epitaxial layer 2 and the depositing film 4 is oxidized when the exposed portion of the N⁻-type silicon carbide epitaxial layer 2 is protected, for example, by the depositing film 4 of about 1000 A. As such, when the thermal oxide film 5 is formed, the exposed portion of the N⁻-type silicon carbide epitaxial layer 2 is not exposed to the outer space. Consequently, the impurity contamination from the outer field can be prevented. Thus, it is possible to effectively reduce the interface state.

Next, in the process shown in FIG. 2G, the gate electrode 6 is deposited on the surface of the depositing film 4. The gate electrode 6 may include, for example, a polycrystal silicon containing impurities introduced. Then, in the process shown in FIG. 2H, a resist mask (not shown) is formed by applying a resist on the surface of the gate electrode 6, i.e., a surface opposing the depositing film 4, and patterning by photolithography. The gate electrode 6, the depositing film 4 and the thermal oxide film 5 are patterned by adopting the resist mask (not shown) as a mask. Thereafter, the interlayer insulating film 9 is formed, and a contact hole is opened. Finally, the source electrode 7 and the drain electrode 8 are formed to thereby accomplish the semiconductor device shown in FIG. 1.

A restraint of the oxide film thickness of the N⁺-type polycrystal silicon 3 is explained with reference to FIG. 3 according to one of the embodiments. As shown in FIG. 3, the thickness of the oxide film increases proportional to an oxidization tim e directly after the oxidization of the silicon is started. However, it is generally known that if the thickness of the oxide film exceeds a certain degree, the oxidization speed is gradually reduced since a diffusion of oxidized species is restrained by the previously existing oxide film. A region wherein the thickness of the oxide film increases proportional to the oxidization time is referred to as a reaction rate-limiting region. Further, a region wherein the oxidization speed is gradually reduced is referred to as a diffusion rate-limiting region. In the first embodiment, after the depositing film 4 is deposited for about 1000 A to be in contact with the N⁺-type polycrystal silicon 3, the thermal treatment is started in the oxidizing atmosphere. As such, compared to a case where the depositing film 4 is not deposited on the N⁺-type polycrystal silicon 3, it is possible to reduce the oxidization speed of the N⁺-type polycrystal silicon 3. Specifically, it is possible to suppress the thermal oxide film 5 for at least equal to or less than hundreds of A on the N⁺-type polycrystal silicon 3. As a result, while restraining the thermal oxide film 5 on the N⁺-type polycrystal silicon 3 from becoming greatly thicker, the thin thermal oxide film 5 is formed on the interface of the N⁻-type silicon carbide epitaxial layer 2 and the depositing film 4.

In the method of manufacturing the semiconductor device according to the first example, the N⁺-type silicon carbide substrate 1 having the silicon carbide as the base material is formed, and the N⁻-type silicon carbide epitaxial layer 2 is formed on the surface of the N⁺-type silicon carbide substrate 1. By contacting the surface of the N⁻-type silicon carbide epitaxial layer 2, the N⁺-type polycrystal silicon 3 is formed. The N⁺-type polycrystal silicon 3 has the polycrystal silicon 10 having a band gap different from the silicon carbide as the base material. Further, the depositing film 4 is deposited to thereby contact a part of the heterojunction portion of the N⁻-type silicon carbide epitaxial layer 2 and the N⁺-type polycrystal silicon 3. After the deposition, the insulating film is formed by performing a thermal treating in the oxidizing atmosphere and oxidizing the N⁻-type silicon carbide epitaxial layer 2 and the N⁺-type polycrystal silicon 3. As a result, since it is possible to reduce the oxidization speed of the N⁺-type polycrystal silicon 3, it is possible to make the oxidization speed of the N⁺-type polycrystal silicon 3 close to the oxidization speed of the silicon carbide. That is, even when the N⁻-type silicon carbide epitaxial layer 2 and the N⁺-type polycrystal silicon 3 are oxidized at the same time, it is possible to make the thickness of the thermal oxide film 5 formed of the N⁺-type polycrystal silicon 3 close to the thickness of the thermal oxide film 5 formed of the N⁻-type silicon carbide epitaxial layer 2. Therefore, it is possible to make the thickness of the thermal oxide film 5 relatively uniform. Further, since the thermal oxide film 5 is formed, it is possible to reduce the interface state density, etc., compared to a case where only the depositing film 4 is formed. Consequently, it is possible to improve the interface characteristic with the N⁻-type silicon carbide epitaxial layer 2. Thus, it is possible to manufacture the semiconductor device with high reliability and current driving force.

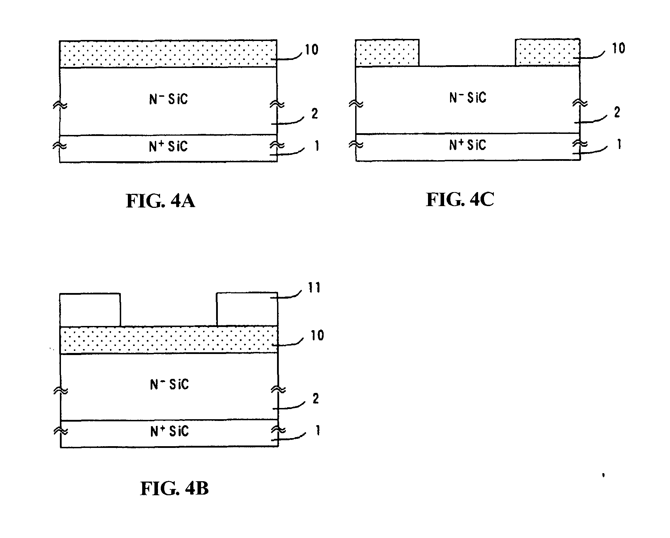

Next, a method of manufacturing a semiconductor device in accordance with an embodiment is explained with reference to FIGS. 4A to 4G. Herein, the same structures as in the first embodiment are denoted by the same reference numerals. Thus, the explanations thereof are not repeated. Here, the semiconductor device manufactured by the method according to the second embodiment is the same as that of the first embodiment shown in FIG. 1. The method of the embodiment differs from that of the first example in that the process of introducing the impurities into the polycrystal silicon 10 is performed after the process of forming the thermal oxide film 5. As a result, the same effects of the first example can be obtained.

Here, the process shown in FIG. 4A is the same as that shown in FIG. 2A. Next, as shown in FIG. 4B, the resist mask 11 is formed by applying a resist on the surface of the polycrystal silicon 10, i.e., a surface opposing the N⁻-type silicon carbide epitaxial layer 2, and patterning via photolithography. Then, as shown in FIG. 4C, the polycrystal silicon 10 is etched by adopting the resist mask 11 as a mask to expose the N⁻-type silicon carbide epitaxial layer 2. Thereafter, the resist mask 11 is removed. The etching method may include dry etching.

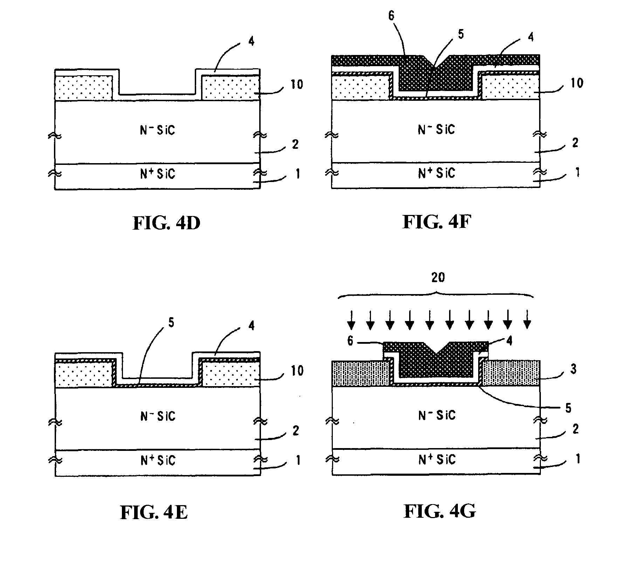

Next, as shown in FIG. 4D, the depositing film 4 is, for example, deposited for about 1000 A to be in contact with the N⁻-type silicon carbide epitaxial layer 2 and the polycrystal silicon 10. As for the depositing film 4, a silicon oxide film can be appropriately used. Further, the deposition method m ay include a thermal CVD method, a plasma CVD method or a sputter method. Then, as shown in FIG. 4E, after the depositing film 4 is deposited, a thermal treatment is performed in an oxidizing atmosphere. The oxidizing atmosphere may include atmospheres used in each of a wet oxidization, a dry oxidization and a pyrogenic oxidization, etc. The temperature of the thermal treatment may be, for example, about 1100°C. By the process shown in FIG. 4E, oxygen diffused in the previously deposited depositing film 4 arrives at the interface of the N⁻-type silicon carbide epitaxial layer 2 and the depositing film 4, thereby oxidizing the N⁻-type silicon carbide epitaxial layer 2 for several A to tens of A. Simultaneously, the top and side surfaces of the polycrystal silicon 10 are oxidized. Thus, as in the first embodiment, the thermal oxide film 5 is formed.

Further, oxidization is enhanced when the silicon has the impurity concentration equal to or more than 5×10¹⁸ cm⁻³. In the method of manufacturing the semiconductor device according to the embodiment, when the thermal process is performed in the oxidizing atmosphere after the deposition of the depositing film 4, the polycrystal silicon 10 is in a state of non-dope. As such, compared to the first example, since the polycrystal silicon 10 is difficult to be oxidized, it is possible to more effectively suppress the thermal oxide film 5 formed of the polycrystal silicon 10 from becoming significantly thicker. Consequently, it is possible to better reduce the oxidization speed of the polycrystal silicon 10. Thus, it becomes possible to make the oxidization speed of the polycrystal silicon 10 close to the oxidization speed of the silicon carbide. As such, it is possible to make the thickness of the thermal oxide film 5 relatively uniform. Then, as shown in FIG. 4F, the gate electrode 6 is deposited on the surface of the depositing film 4. As in the first example, the gate electrode 6 may include the polycrystal silicon containing the impurities introduced.

Next, as shown in FIG. 4G, a resist mask (not shown) is formed by applying a resist on the surface of the gate electrode 6 and patterning via photolithography. The gate electrode 6, the depositing film 4 and the thermal oxide film 5 are patterned by adopting the resist mask (not shown) as a mask. Further, after the thermal oxide film 5 is formed, the N⁺-type polycrystal silicon 3 is formed by introducing the N-type impurities into the polycrystal silicon 10. In the embodiment, the method of introducing the N-type impurities 20 adopts a method of thermally diffusing the N-type impurities 20 after depositing the polycrystal silicon 10 as in the first embodiment. However, as in the first example, the method of introducing the N-type impurities 20 may include a method of ion-injecting the N-type impurities 20 after depositing the polycrystal silicon 10. Further, after the N-type impurities 20 are introduced and the depositing film 4 is then deposited, an active heating treatment may be performed for the N-type impurities 20 at a temperature lower than a temperature when the thermal treatment is performed in the oxidizing atmosphere. Next, the interlayer insulating film 9 is formed, and a contact hole is opened. Finally, the source electrode 7 and the drain electrode 8 are formed to thereby manufacture the semiconductor device, which has the same structure as the semiconductor device shown in FIG. 1.

In the method of manufacturing the semiconductor device according to the embodiment, the N⁺-type silicon carbide substrate 1 having the silicon carbide as the base material is formed, and the N⁻-type silicon carbide epitaxial layer 2 is formed on the surface of the N⁺-type silicon carbide substrate 1. Contacting the surface of the N⁻-type silicon carbide epitaxial layer 2, the polycrystal silicon 10 having the band gap different from the silicon carbide is formed. Also, the depositing film 4 is deposited to be in contact with a part of the heterojunction portion of the N⁻-type silicon carbide epitaxial layer 2 and the polycrystal silicon 10. After the deposition, the insulating film is formed by performing a thermal treatment in the oxidizing atmosphere and oxidizing the N⁻-type silicon carbide epitaxial layer 2 and the polycrystal silicon 10. Further, after the insulating film is formed, the N⁺-type polycrystal silicon 3 is formed by introducing the N-type impurities 20 into the polycrystal silicon 10. As a result, the same effects as in the first example can be obtained.

Further, in the embodiment, the N⁺-type polycrystal silicon 3 is formed by introducing the N-type impurities 20 into the polycrystal silicon 10 after the deposition of the depositing film 4, and then the thermal treatment in the oxidizing atmosphere is performed. As such, since the impurities are extracted or excluded from the heterojunction surface of the N⁻-type silicon carbide epitaxial layer 2 and the N⁺-type polycrystal silicon 3 during such thermal treatment, it is possible to restrain a distribution of the impurities in the heterojunction surface from being changed.

While certain embodiments of the invention are described above, the invention should not be limited to such embodiments. For example, although the methods of manufacturing the semiconductor device in accordance with the first and second embodiments use silicon carbide having 4H poly type as the semiconductor material, the invention is not specifically limited to such component and may include other poly types. Likewise, although silicon carbide is used as the semiconductor material, the invention is not specifically limited to such component and may include gallium nitride or diamond.

Also, although the methods of manufacturing the semiconductor device in accordance with the first example and the embodiment use N⁺-type as the conductive type of the N⁺-type polycrystal silicon 3, the invention is not limited to such a configuration and may use N⁻-type, non-dope type, P⁻-type, etc.

Moreover, although the thickness of the thermal oxide film 5 on the N⁻-type silicon carbide epitaxial layer 2 ranges from several A to tens of A, the invention is not limited thereto and may include any thickness. Likewise, although the thickness of the depositing film 4 is about 1000 Å, the invention is not limited thereto and may include several Å. Further, although a difference between the thickness of the insulating film (that is, the film 5) formed on the N⁺-type polycrystal silicon 3 and the thickness of the insulating film 5 formed on the N⁻-type epitaxial layer 2 is hundreds of Å, thus being relatively uniform, the invention is not limited to such configuration. In other words, the thickness of the insulating film 5 formed on the N⁺-type polycrystal silicon 3 may be up to about two times the thickness of the insulating film 5 formed on the N⁻-type epitaxial layer 2 and still be considered relatively uniform.

## Claims

1. A method of manufacturing a semiconductor device including a semiconductor substrate (1, 2) and a hetero semiconductor region (3) including a semiconductor material having a band gap different from that of the semiconductor substrate (1, 2) and contacting a portion of a first surface of the semiconductor substrate (1, 2), the method comprising:
depositing a first insulating film (4) on exposed portions of the first surface of the semiconductor substrate (1, 2) and on exposed surfaces of the hetero semiconductor material (3); and
forming a second insulating film (5) between the first insulating film (4) and facing surfaces of the semiconductor substrate (1, 2) and the hetero semiconductor region (10) by performing a thermal treatment in an oxidizing atmosphere, wherein when the thermal treatment is performed in the oxidizing atmosphere after the deposition of the first insulating film (4), the hetero semiconductor region (10) is in a state of non-dope, the method further comprising
forming the hetero semiconductor region (10) on the portion of the first surface of the semiconductor substrate (1, 2) before depositing the first insulating film (4); and
introducing doping impurities into the hetero semiconductor region (10) after forming the second insulating film (5).

2. A method as claimed in claim 1, wherein a thickness of the second insulating film (5) between the exposed surfaces of the hetero semiconductor region (10) and the first insulating film (4) is no more than about two times a thickness of the second insulating film (5) between the exposed portions of the first surface of the semiconductor substrate (1, 2) and the first insulating film (4).

3. A method as claimed in any preceding claim, wherein forming the second insulating film (5) comprises performing at least one of a wet oxidization, a dry oxidization and a pyrogenic oxidization.

4. A method as claimed in any preceding claim, comprising:
depositing a gate electrode (6) on an exposed surface of the first insulating film (4) opposite the second insulating film (5);
forming a source electrode (7) in electrical contact with the hetero semiconductor region (10); and
forming a drain electrode (8) in ohmic-connection with the semiconductor substrate (1, 2) on a second surface of the semiconductor substrate (1, 2) opposed to the first surface.

5. A method as claimed in any preceding claim, wherein the semiconductor substrate comprises at least one of silicon carbide, gallium nitride and diamond.

6. A method as claimed in any preceding claim, wherein the hetero semiconductor material is polycrystal silicon.

## Patentansprüche

1. Verfahren zum Herstellen einer Halbleitervorrichtung, die ein Halbleiter-Substrat (1, 2) und einen Hetero-Halbleiterbereich (3) umfasst, der ein Halbleitermaterial mit einer Bandlücke aufweist, die sich von der des Halbleiter-Substrats (1, 2) unterscheidet und einen Bereich einer ersten Oberfläche des Halbleiter-Substrats (1, 2) berührt, wobei das Verfahren umfasst:
Abscheiden einer ersten Isolierschicht (4) auf freiliegenden Bereichen der ersten Oberfläche des Halbleiter-Substrats (1, 2) und freiliegenden Oberflächen des Hetero-Halbleiterbereichs (3); und
Ausbilden einer zweiten Isolierschicht (5) zwischen der ersten Isolierschicht (4) und zugewandten Flächen des Halbleiter-Substrats (1, 2) und dem Hetero-Halbleiterbereich (10) durch Ausführen einer Wärmebehandlung in einer oxidierenden Atmosphäre, wobei, wenn die Wärmebehandlung in der oxidierenden Atmosphäre nach dem Abscheiden der ersten Isolierschicht (4) ausgeführt wird, der Hetero-Halbleiterbereich sich in einem nicht-dotierten Zustand befindet, wobei das Verfahren ferner umfasst
Ausbilden des Hetero-Halbleiterbereichs (10) auf dem Bereich der ersten Oberfläche des Halbleiter-Substrats (1, 2) vor dem Abscheiden der ersten Isolierschicht (4); und
Einleiten von Dotierungsverunreinigungen in den Hetero-Halbleiterbereich(10) nach dem Ausbilden der zweiten Isolierschicht (5).

2. Verfahren nach Anspruch 1, wobei eine Dicke der zweiten Isolierschicht (5) zwischen den freiliegenden Oberflächen des Hetero-Halbleiterbereichs (10) und der ersten Isolierschicht (4) nicht mehr als ca. zweimal eine Dicke der zweiten Isolierschicht (5) zwischen den freiliegenden Bereichen der ersten Oberfläche des Halbleiter-Substrats (1, 2) und der ersten Isolierschicht (4) beträgt.

3. Verfahren nach einem der vorhergehenden Ansprüche, wobei das Ausbilden der zweiten Isolierschicht (5) das Ausführen zumindest einer aus einer Nassoxidation, einer Trockenoxidation und einer pyrogenen Oxidation umfasst.

4. Verfahren nach einem der vorhergehenden Ansprüche, umfassend:
Abscheiden einer Gate-Elektrode (6) auf einer freiliegenden Oberfläche der ersten Isolierschicht (4) gegenüber der zweiten Isolierschicht (5);
Ausbilden einer Source-Elektrode (7) in elektrischem Kontakt mit dem Hetero-Halbleiterbereich (10); und
Ausbilden einer Drain-Elektrode (8) in ohmscher Verbindung mit dem Halbleiter-Substrat (1, 2) auf einer zweiten Oberfläche des Halbleiter-Substrats (1, 2) gegenüber der ersten Oberfläche.

5. Verfahren nach einem der vorhergehenden Ansprüche, wobei das Halbleiter-Substrat zumindest eines aus Siliziumkarbid, Galliumnitrid und Diamant aufweist.

6. Verfahren nach einem der vorhergehenden Ansprüche, wobei das Hetero-Halbleitermaterial polykristallines Silizium ist.

## Revendications

1. Procédé de fabrication d'un dispositif semi-conducteur comportant un substrat semi-conducteur (1, 2) et une région semi-conductrice d'hétérojonction (3) comportant un matériau semi-conducteur ayant une bande interdite différente de celle du substrat semi-conducteur (1, 2) et en contact avec une partie d'une première surface du substrat semi-conducteur (1, 2), le procédé comprenant :
le dépôt d'un premier film isolant (4) sur des parties exposées de la première surface du substrat semi-conducteur (1, 2) et sur des surfaces exposées du matériau semi-conducteur d'hétérojonction (3) ; et
la formation d'un deuxième film isolant (5) entre le premier film isolant (4) et des surfaces en vis-à-vis du substrat semi-conducteur (1, 2) et de la région semi-conductrice d'hétérojonction (10) en effectuant un traitement thermique dans une atmosphère oxydante, où lorsque le traitement thermique est effectué dans l'atmosphère oxydante après le dépôt du premier film isolant (4), la région semi-conductrice d'hétérojonction (10) se trouve dans un état non dopé, le procédé comprenant en outre
la formation de la région semi-conductrice d'hétérojonction (10) sur la partie de la première surface du substrat semi-conducteur (1, 2) avant le dépôt du premier film isolant (4) ; et
l'introduction d'impuretés dopantes dans la région semi-conductrice d'hétérojonction (10) après la formation du deuxième film isolant (5).

2. Procédé tel que revendiqué dans la revendication 1, dans lequel une épaisseur du deuxième film isolant (5) entre les surfaces exposées de la région semi-conductrice d'hétérojonction (10) et le premier film isolant (4) ne dépasse pas environ deux fois une épaisseur du deuxième film isolant (5) entre les parties exposées de la première surface du substrat semi-conducteur (1, 2) et le premier film isolant (4).

3. Procédé tel que revendiqué dans l'une des revendications précédentes, dans lequel la formation du deuxième film isolant (5) comprend la réalisation d'au moins l'une d'une oxydation humide, d'une oxydation sèche et d'une oxydation pyrogène.

4. Procédé tel que revendiqué dans l'une des revendications précédentes, comprenant : le dépôt d'une électrode de grille (6) sur une surface exposée du premier film isolant (4) opposée au deuxième film isolant (5) ;
la formation d'une électrode de source (7) en contact électrique avec la région semi-conductrice d'hétérojonction (10) ; et
la formation d'une électrode de drain (8) en connexion ohmique avec le substrat semi-conducteur (1, 2) sur une deuxième surface du substrat semi-conducteur (1, 2) opposée à la première surface.

5. Procédé tel que revendiqué dans l'une des revendications précédentes, dans lequel le substrat semi-conducteur comprend au moins l'un du carbure de silicium, du nitrure de gallium et du diamant.

6. Procédé tel que revendiqué dans l'une des revendications précédentes, dans lequel le matériau semi-conducteur d'hétérojonction est du silicium polycristallin.
